# EUROPEAN PATENT APPLICATION

(11) **EP 2 508 656 A1**
(43) Date of publication of application: **10.10.2012**
(21) Application number: 10833378.2
(22) Date of filing: 29.11.2010
(51) Int. Cl.: C30B 29/38, C30B 25/02

(54) **PROCESS FOR PRODUCING SINGLE-CRYSTAL ALUMINUM NITRIDE**

(30) Priority: 30.11.2009 JP 2009272418
(71) Applicant: Tohoku University, Aoba-ku Sendai-shi Miyagi 980-8577 (JP); Tokuyama Corporation, Shunan-shi, Yamaguchi 745-8648 (JP)
(72) Inventor: FUKUYAMA, Hiroyuki, Sendai-shi Miyagi 980-8577 (JP); AZUMA, Masanobu, Shunan-shi Yamaguchi 745-8648 (JP); TAKADA, Kazuya, Shunan-shi Yamaguchi 745-8648 (JP); HATTORI, Takeshi, Sendai-shi Miyagi 980-8577 (JP)
(74) Representative: Schlief, Thomas P.
(86) International application number: PCT/JP2010/071259
(87) International publication number: WO 2011/065534

(57) **Abstract**

Provided is a process for efficiently and easily producing single-crystal aluminum nitride having satisfactory crystallinity. The process for single-crystal aluminum nitride production comprises passing nitrogen gas in the presence of a molded carbon object and a starting-material gas source that generates aluminum gas or aluminum oxide gas and growing single-crystal aluminum nitride in a heated environment. The process is characterized in that the starting-material gas source, part of which is not in contact with the molded carbon object, and the molded carbon object, part of which is not in contact with the starting-material gas source, are disposed so that there is a space of 0.01-50 mm between the part of the starting-material gas source and the part of the molded carbon object, and that a heating temperature and a nitrogen gas flow rate are set so as to satisfy conditions under which aluminum nitride deposits in the space between the part of the starting-material gas source which is not in contact with the molded carbon object and the part of the molded carbon object which is not in contact with the starting-material gas source.

## Description

### TECHNICAL FIELD

The present invention relates to a novel production method of aluminum nitride single crystal having good crystallinity.

### DESCRIPTION OF THE RELATED ART

Aluminum nitride is a material having a high mechanical strength and superior in radiation performance, therefore, it is used as a filler, a substrate of electronic and electric components and thermolytic member. Specifically, AIN single crystal is of particular interest as a substrate material constituting light-emitting device such as light-emitting diode (LED) or laser diode (LD), which emit short-wavelength light of blue light visible range-ultraviolet range, in view of lattice consistency and ultraviolet light permeability.

Currently, an aluminum nitride single crystal is manufactured as thin fillm single crystal or bulk single crystal by a vapor phase growth method, such as a metal-organic vapor phase epitaxy method (MOVPE method) or a hydride vapor phase epitaxy method (HVPE method), a chemical transport method, a flux method, a sublimation recrystallization method, etc. Above all, with the chemical transport method or the sublimation recrystallization method, single crystals having different forms, such as plate crystals or needle crystals, with a high crystallinity can be obtained; thus, various studies have been conducted.

Concretely, a production method (See Japanese Unexamined Patent Publication 2005-132699: Patent Article 1) of needle and plate formed aluminum nitride single crystal is proposed, wherein raw materials of alumina and the other metal oxide are heated in nitrogen atmosphere in the presence of carbon at a temperature of 1650°C or more to 2200°C or less. However, there is still a room for improvement with the method described in Patent Article 1, since the obtained aluminum nitride single crystal is likely to include impurity, due to the fact that it uses the metal oxide other than alumina. Further, a deposition place of aluminum nitride cannot be controlled, and it was difficult to selectively deposit aluminum nitride in a required place. Further, with Patent Article 1, raw materials, such as alumina, are contained in a carbon made crucible, and then heated in a nitrogen atmosphere putting a top of the crucible. With the top, circulation of nitrogen is inhibited and that production efficiency of the aluminum nitride is considered insufficient.

### PRIOR ART

[Patent Article 1] Japanese Laid-Open Patent Publication No. 2005-132699

### DISCLOSURE OF INVENTION

### PROBLEM TO BE SOLVED BY THE INVENTION

The present invention has been made by considering the above conventional arts, and a purpose of the present invention is to provide a method wherein an aluminum nitride single crystal having a good crystallinity is efficiently and easily manufactured.

### MEANS FOR SOLVING THE PROBLEM

Currently, aluminum nitride polycrystalline powder used widely as aluminum nitride is obtained by heating an alumina powder and a carbon powder in nitrogen atmosphere. In this case, raw material gas produced from alumina will immediately reduce and nitride by adjacent carbon source; therefore it is thought that single crystal will not be obtained while polycrystalline powder will be produced. From this consideration, the present inventors conceived of a possibility of efficiently obtaining an aluminum nitride single crystal by not immediately reduce and nitride the raw material gas generated from alumina or so, but deposit after maintaining a floating situation to some extent. The present invention, achieved from such consideration, includes the following matters.
(1) A production method of an aluminum nitride single crystal wherein nitrogen gas is circulated in the presence of a raw material gas generation source, which generates an aluminum gas or an aluminum oxide gas, and a carbon body, and then the aluminum nitride single crystal is grown under a heating condition; characterized in that,
   at least a part of the carbon body does not directly contact with the raw material gas generation source,
   at least a part of the raw material gas generation source does not directly contact with the carbon body,
   the raw material gas generation source and the carbon body are positioned to make a space in which a clearance between the raw material gas generation source, which does not contact with the carbon body, and the carbon body, which does not contact with the raw material gas generation source, is 0.01 to 50mm, and
   a heat temperature and a nitrogen gas flow rate are set so as to satisfy a condition for aluminum nitride deposition in a space between the raw material gas generation source, which does not contact with carbon body, and the carbon body, which does not contact with raw material gas generation source.
(2) The production method of the aluminum nitride single crystal described in (1), wherein the raw material gas generation source is an aluminum oxide body.
(3) The production method of the aluminum nitride single crystal as described in (2), wherein the carbon body, smaller in size than the aluminum oxide body, is set on the aluminum oxide body.
(4) The production method of the aluminum nitride single crystal as described in (2), wherein a clearance between the aluminum oxide body and the carbon body is 0.05 to 40mm.
(5) The production method of the aluminum nitride single crystal as described in (3) or (4), wherein an aluminum nitride body, a substrate for an aluminum nitride single crystal growth, is placed close to the aluminum oxide body and the carbon body.
(6) The production method of the aluminum nitride single crystal as described in any one of (1) to (5), wherein the nitrogen gas is circulated with an amount of 0.1 cc/min. to 100L/min., when converted to 23°C, in a space between the raw material gas generation source, which does not contact with the carbon body, and the carbon body, which does not contact with the raw material gas generation source.

### EFFECTS OF THE INVENTION

The present invention discloses a method wherein an aluminum nitride single crystal having good crystallinity is efficiently and easily manufactured.

### BRIEF DESCRIPTION OF THE DRAWINGS

- **Fig. 1**: is a production equipment preferably used for producing an aluminum nitride single crystal, and is a schematic sectional view showing an example of a positional relation of a raw material gas generation source and a carbon body.
- **Fig. 2**: is a schematic sectional view showing an example of a positional relation of a raw material gas generation source and a carbon body.
- **Fig. 3**: is a schematic sectional view showing an example of a positional relation of a raw material gas generation source, a carbon body and a substrate for an aluminum nitride single crystal growth.
- **Fig. 4**: is a picture showing a growth state of a single crystal aluminum nitride.

### EMBODIMENTS OF THE INVENTION

Hereinafter, the present invention will be described in detail including its best mode of the invention referring to its drawings.

Production method of an aluminum nitride single crystal according to the present invention is, at first, to dispose raw material gas generation source 5, which generates aluminum gas or aluminum oxide gas, and carbon body 6, so as to satisfy their predetermined positional relation.

### (Aluminum nitride single crystal production equipment)

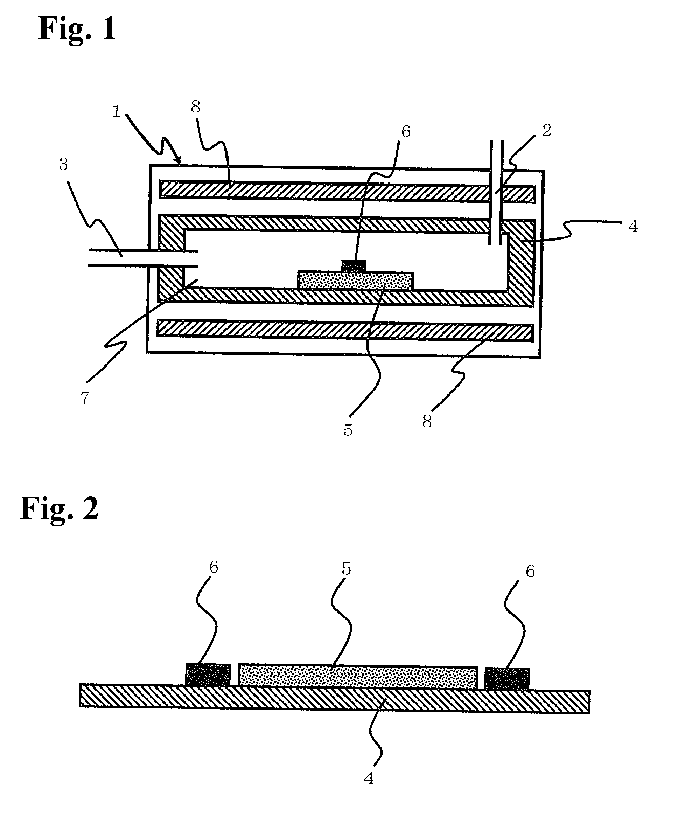

Fig. 1 is an example of a schematic sectional view of single crystal production equipment preferably used in the producing method of an aluminum nitride single crystal according to the present invention. Hereinafter, the present invention will be described in detail with this Fig. 1, however, the present invention will not be limited to the following embodiments.

Said single crystal production equipment 1 is equipped with a reaction container 4 comprising nitrogen gas feed opening 2, which feed nitrogen gas and located at its upstream, and exhaust opening 3, which exhaust gas within a system and located at its downstream. In the reaction container 4, raw material gas generation source 5 and carbon body 6 are disposed to satisfy their predetermined positional relation. Reaction container 4 allows to be heated by heater 8.

Note that in the single crystal production equipment, each member such as reaction container 4, nitrogen gas feed opening 2 and exhaust opening 3, are obviously constituted from materials that are sufficiently enduring to a temperature when growing aluminum nitride single crystals.

According to the present invention, aluminum nitride single crystals are possible to grow by using the single crystal production equipment; and its method will be described in detail hereinafter.

### (Reaction container)

Reaction container 4 used in the present invention is constituted from a material sufficiently enduring to a temperature when growing aluminum nitride single crystals, in concrete, 1500°C or more and 2400°C or less. As for a specific material, a sintered body of aluminum nitride or boron nitride, carbon, etc. can be exemplified. Above all, considering purities of producing aluminum nitride single crystals, reaction container 4 is preferably constituted from aluminum nitride sintered body. Further, it is preferable to use aluminum nitride sintered body in which a sintering additive is not included.

Shapes and sizes of reaction container 4 are not particularly limited, and would be within a realm of the industrial production possibility. Above all, a cylindrical shape is preferable, considering that reaction container 4 can be easily made and nitrogen gas, supplied when growing aluminum nitride single crystals, can be easily supplied to the reaction container 4 uniformly.

### (Raw material gas generation source)

Raw material gas generation source 5 is made from a material generating raw material aluminum gas, which reacts with nitrogen and produces aluminum nitride. Raw material aluminum gas of the present invention is aluminum gas or aluminum oxide gas. Metal aluminum is used when generating aluminum gas and aluminum oxide (alumina, sapphire) is used when generating aluminum oxide gas.

An oxidized aluminum will suffice as the aluminum oxide; and commercial aluminum oxide, sapphire or oxidized aluminum nitride can be used. As for the oxidized aluminum nitride, a preliminary oxidized aluminum nitride out of the reaction container and also an aluminum nitride oxidized inside the reaction container can be used.

Above all the aluminum oxides, so as to simplify processes and to improve yield of the obtained aluminum nitride single crystal, general aluminum oxide or sapphire (hereinafter, "Al₂O₃" refers to the general aluminum oxide or sapphire and not to the oxidized aluminum nitride) rather than oxidized aluminum nitride are preferably used.

When using aluminum oxide (Al₂O₃) in the present invention, although it is not particularly limited, a high-purity aluminum oxide is preferably used considering the purity of obtained aluminum nitride single crystal. However, impurity inevitably mixed when producing commercial aluminum oxide is not excluded; and a purity of aluminum oxide (Al₂O₃) is preferably 99% or more, further preferably 99.9% or more.

A shape of the above raw material gas generation source is not particularly limited, and can be a plate-shape, a granulated shape or a powder-shape. However, in the present invention, especially aluminum oxide body, alumina plate in concrete, is preferably used. When using granulated or powdered raw material gas generation source, production of raw material gas is rapid; and thus good single crystals may not be obtained.

Aluminum oxide which satisfies these requirements is commercially available; and its examples are aluminum oxide of Wako grade by Wako Pure Chemical Industries, Ltd. and aluminum oxide of ALO01 PB, ALO02PB, ALO03PB, ALO16PB, ALO13PB, ALO14PB, ALO11PB and ALO12PB by Kojundo Chemical Laboratory Co., which can be used. Further, alumina A-479, A-480, A-601 by KYOCERA Corporation and single crystal sapphire also by KYOCERA Corporation can be used. As for metal aluminum, commercially available AIE series of granular-type, rod-type, tablet-type, chip-type, plate-type and foil-type having 99% or more purity by Kojundo Chemical Laboratory Co. can be used.

### (Carbon Body)

In the present invention, carbon body 6 is used as a reducing agent when reduce and nitride the raw material gas. Although a shape of carbon body 6 is not particularly limited as long as it is formed, block type is preferable. Therefore, as for a preferable carbon body, a block wherein carbon powder, such as carbon black, is formed with a small amount of binder resin or a block which is formed by shaving graphite or so, can be exemplified.

When carbon powder is used as a reducing agent in the production method of the present invention, gasification and reduction and nitridation reactions of carbon rapidly occur and the carbon disappear from reaction system before the reaction sufficiently proceeds, or aluminum nitride rapidly produces; and that good single crystal cannot be obtained.

However, when carbon body is used as a reducing agent, gasification of carbon is limited to the body surface; and that rapid gasification of carbon is limited. As a result, reduction gas (carbon monoxide gas or so) amount produced from the carbon body becomes appropriate and reduction and nitridation reactions are suitably controlled; and thus good single crystals are obtained. In order to control such rapid gasification of carbon, effective surface area per weight of the carbon body used in the invention is preferably 0.5m²/g or less, more preferably 0.25m²/g or less, and particularly preferably 0.025m²/g or less. Here, effective surface area is a surface area which pores are not considered; and in case of a rectangular parallelepiped, effective surface area is a total area of top and bottom surfaces and 4 side surfaces.

### (A positional relation of raw material gas generation source 5 and carbon body 6)

According to the present invention, aluminum nitride is produced under a condition where raw material gas generation source 5 and carbon body 6 satisfy a predetermined positional relation.

To be concrete, raw material gas generation source 5 and carbon body 6 are positioned so that at least a part of carbon body 6 does not directly contact with raw material gas generation source 5, at least a part of raw material gas generation source 5 does not directly contact with carbon body 6, and a space is made wherein a clearance between raw material gas generation source 5 and carbon body 6 is 0.01 to 50mm, preferably 0.05 to 40mm, more preferably 0.08 to 30mm, further more preferably 0.1 to 25mm, particularly more preferably 0.3 to 20mm and the most preferably 0.8 to 15mm.

Note that "clearance" is a length of a straight line connecting arbitrary "raw material gas generation source 5 which does not contact with carbon body 6" and its closest "carbon body 6 which does not contact with raw material gas generation source 5".

Further, "to make a space" defines a condition wherein the other raw material gas generation source 5 or the other carbon body 6 do not exist on said straight line.

Further, in the invention, a length of the straight line connecting "raw material gas generation source 5 which does not contact with carbon body 6" and "carbon body 6 which does not contact with raw material gas generation source 5" does not necessary be in the above mentioned rage. Namely, it will be sufficient that a part of raw material gas generation source 5 and that of carbon body 6 satisfy the above relation. Therefore, raw material gas generation source 5 and carbon body 6 may partly contact. Clearance between the two will be 0 (zero) at a contacting place. Further, clearance between a part of raw material gas generation source 5 and that of carbon body 6 may be over 50mm.

In case of a mixture of carbon powder and alumina powder, carbon powder and alumina powder are uniformly mixed; and thus, even if "alumina powder which does not contact with carbon powder" and "carbon powder which does not contact with alumina powder" exist, clearance of the two does not satisfy the above relation since they are adjacent to each other.

On the other hand, when carbon body is used as a carbon source as is mentioned above, at least a part of carbon body does not contact with raw material gas generation source 5, unless all around carbon body 6 is wrapped with raw material gas generation source 5. Further, "raw material gas generation source 5 which does not contact with carbon body 6" can be realized by such as a carbon body smaller than raw material gas generation source 5. In concrete, this can be realized by using alumina plate, which has larger area than bottom surface area of carbon body 6 and then placing carbon body on the alumina plate, or by laying alumina powder in reaction container making its area larger than bottom surface area of carbon body 6, and then placing carbon body on the alumina powder.

Further specific example of positional relation between such raw material gas generation source 5 and carbon body 6 is shown in Fig. 1. Fig. 1 shows a condition wherein, on raw material gas generation source 5 (such as alumina plate), carbon body 6 (such as carbon block) which has smaller area than said source 5 is placed. In this case, a part of upper surface of alumina plate contacts with bottom surface of carbon block. However, other than the contact surface with the carbon block, alumina plate does not contact with the carbon block. Accordingly, "raw material gas generation source 5 which does not contact with carbon body 6" exists. Similarly, carbon block does not contact with alumina plate other than its bottom surface. Therefore, "carbon body 6 which does not contact with raw material gas generation source 5" exists. In the present invention, "alumina plate which does not contact with carbon block" and "carbon block which does not contact with alumina plate" are positioned so as to make their clearance satisfy the above.

Accordingly, in case of a position shown in Fig. 1, and when size of the carbon block is small, such as 0.01 mm cubic, the above relation will not be satisfied. Therefore, it is recognized that a certain size of carbon block is required; and that granular or powder carbon will not be used in the invention.

Fig. 2 shows the other example of positional relation between raw material gas generation source 5 and carbon body 6. Fig. 2 shows a condition wherein alumina plate and carbon block are positioned in parallel with a predetermined clearance. In this case, the two do not contact and that "alumina plate which does not contact with carbon block" and "carbon block which does not contact with alumina plate" exist. Therefore, defined position according to the present invention can be realized by making a clearance between a side surface of alumina plate and that of carbon block to 0.01 to 50mm.

According to the invention, so as to satisfy a condition wherein aluminum nitride deposit in a space between raw material gas generation source which does not contact with carbon body and carbon body which does not contact with raw material gas generation source, heat temperature and nitrogen gas flow rate are set and then an aluminum nitride single crystal is obtained. However, according to the invention, spaces other than the above space may satisfy the deposition conditions of aluminum nitride; and in fact, this is more preferable. Namely, according to the invention, the above defined predetermined space is required to satisfy the deposition conditions of aluminum nitride; and in addition, the other spaces are preferable to satisfy the deposition conditions of aluminum nitride.

### (A substrate for an aluminum nitride single crystal growth)

In case when the other spaces, not involving the above defined predetermined space, satisfy the deposition conditions of aluminum nitride, it is preferable to place a substrate for an aluminum nitride single crystal growth 7 in said other spaces and to grow an aluminum nitride single crystal on a substrate for an aluminum nitride single crystal growth 7. A high purity aluminum nitride single crystal can be manufactured by growing an aluminum nitride single crystal on a substrate for an aluminum nitride single crystal growth. Note that here, a shape of "a substrate for an aluminum nitride single crystal growth" can be any size, which is easy in handling in response to a content of reaction container, aluminum oxide used, and an amount of an aluminum nitride single crystal obtained.

According to the invention, said substrate for an aluminum nitride single crystal growth is not particularly limited as long as it is a material suitable for aluminum nitride growth, however, a substrate made of aluminum nitride material is preferable. Specifically, a substrate comprising aluminum nitride single crystals or aluminum nitride sintered body can be used. Above all, according to the present invention, a substrate comprising aluminum nitride sintered body (hereinafter referred to as aluminum nitride sintered body substrate) is preferably used.

Said aluminum nitride sintered body substrate can be manufactured with a known method or a commercial aluminum nitride sintered body substrate can be used. An aluminum nitride single crystal can be high-yield by using aluminum nitride sintered body substrate. Reason for this is not clear; however, it would appear that aluminum nitride sintered body is polycrystal and particles having various shapes and various crystal faces exist on its surface, and thus, the particles tend to become core when growing aluminum nitride single crystals. As for a preferable aluminum nitride sintered body substrate, it is preferable to use a substrate which has a particle diameter within a range of 1 to 30µm when observed with electronic microscope.

Further, it is preferable to use the aluminum nitride sintered body substrate including sintering additive of less than 40000ppm, and more preferable to use the substrate not including the sintering additive, when purity of the obtained aluminum nitride single crystal is considered. Note that said aluminum nitride sintered body substrate including oxygen is preferably used. Specifically, the substrate including 100 to 25000ppm, preferably 500 to 7000ppm of oxygen is used. Reason for this is also not clear; however, it would appear that an aluminum nitride single crystal growth is promoted by using the aluminum nitride sintered body substrate including oxygen to some extent. The aluminum nitride sintered body substrate can also be produced with a known method or commercial substrates, such as SH-50 and SH-15 by Tokuyama Corporation, can be used.

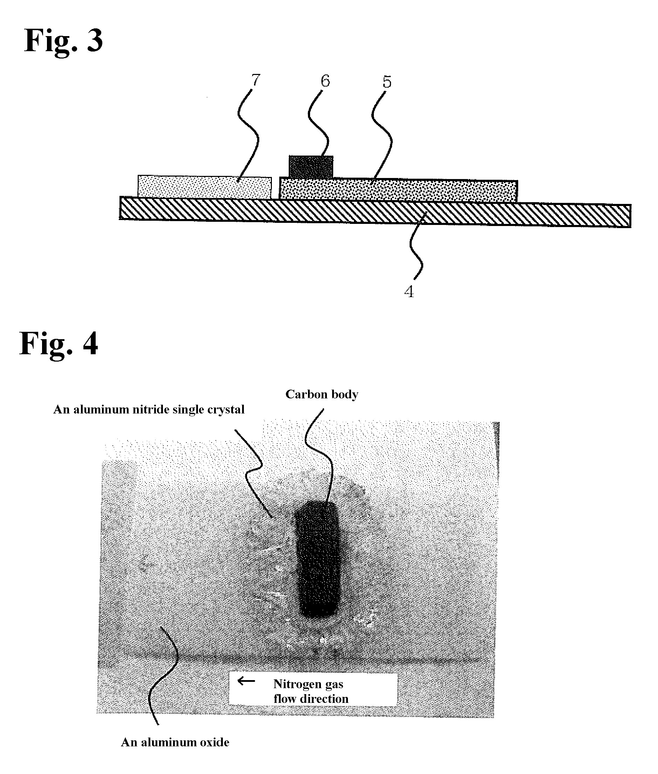

However, according to the present invention as is described above, so as to surely satisfy the aluminum nitride deposition conditions in a space between the raw material gas generation source which does not contact with carbon body and the carbon body which does not contact with raw material gas generation source, substrate for an aluminum nitride single crystal growth 7 is preferably placed close to the space, specifically, substrate 7 is placed in order that at least a part of substrate 7 is placed within 0.01 mm from the space, as is shown in Fig. 3.

### (An aluminum nitride single crystal growth method)

In the present invention, raw material gas generation source 5, carbon body 6 and substrate for an aluminum nitride single crystal growth 7, used when necessary, are placed satisfying particular positional relation; and then nitrogen gas is circulated from nitrogen gas feed opening 2 and aluminum nitride single crystals are grown under a heating condition.

As for a nitrogen gas, pure nitrogen or a gas diluted with inert gases other than nitrogen can be circulated. As for inert gases other than nitrogen, inert gases such as argon, helium, neon, krypton, xenon, etc. can be used. Circulation amount of nitrogen gas is particularly not limited as long as it produces aluminum nitride, and it varies depending on various thermodynamic conditions, such as heat treatment temperature. However, for an efficient aluminum nitride production, it is desirable to circulate nitrogen in a space between the raw material gas generation source, which does not contact with carbon body, and the carbon body, which does not contact with raw material gas generation source, with an amount of 0.1cc/min. to 100L/min., preferably 1cc/min. to 50L/min., more preferably 30cc/min. to 30L/min., particularly preferably 50cc/min. to 20L/min. when converted to 23°C.

According to the present invention, when nitrogen gas is circulated in a reaction container within the above flow rate, yield of the obtained aluminum nitride single crystals increases with the increase of the circulation flow rate.

According to the present invention, temperature in the reaction container is particularly not limited, as long as the raw material gas generation source generates the raw material gas and the raw material gas produces aluminum nitride by reduction and nitridation, and it varies depending on various thermodynamic conditions, such as a nitrogen partial pressure existing in reaction system. Further, raw material gas generation source 5, carbon body 6 and a substrate for an aluminum nitride single crystal growth 7, used when necessary, are close to each other, and temperature difference substantially does not exist among them.

Temperature in the reaction container is preferably 1500°C or more to 2400°C or less. In case said temperature is less than 1500°C, aluminum nitride single crystals are difficult to grow, which is not preferable. While when it exceeds 2400°C, the temperature is too high and this is not preferable for an industrial production. Considering industrial production of aluminum nitride single crystals, temperature in the reaction container is preferably 1700°C or more and 2200°C or less, more preferably 1750°C or more and less than 2150°C, and particularly preferably 1750°C or more and 2100°C or less.

According to the present invention, when temperature in the reaction container is controlled within the above temperature range, crystallinity of the obtained aluminum nitride single crystals will improve with the increase of temperature. Further, enlarged crystal particles can be observed. Furthermore, its yield increases.

### (The other conditions)

According to the present invention, an aluminum nitride single crystal can be manufactured by growing an aluminum nitride single crystal on a substrate for an aluminum nitride single crystal growth under the conditions mentioned hereinbefore.

Reaction time (time for growing an aluminum nitride single crystal) is not particularly limited; and can be suitably determined according to desired shape and yield of an aluminum nitride single crystal. The longer the reaction time is, the larger the diameter and the longer the length of the obtained columnar aluminum nitride single crystal are. However, considering industrial production, the reaction time is preferably 1 hr or more to 200hrs or less.

Note that the reaction time is a time measured from the point when all the conditions are right. Namely, it is a time measured from a point when all the conditions satisfy the set conditions, comprising a temperature in the reaction container and a partial pressure of nitrogen gas. Therefore, when setting a temperature in the reaction container to a set temperature by supplying nitrogen gas in the reaction container, the reaction time is a time measured from the point when it reaches the set temperature. And when nitrogen gas is supplied in reaction container after setting a temperature in the reaction container to a set temperature, the reaction time is a time measured from the point when it supplied nitrogen gas.

After growing an aluminum nitride single crystal under these conditions, the temperature of the reaction container is decreased to a room temperature, and then the produced aluminum nitride single crystal is taken out from the reaction container to produce an aluminum nitride single crystal.

### (An aluminum nitride single crystal)

According to the present invention, an aluminum nitride single crystal is produced in a space between raw material gas generation source, which does not contact with carbon body, and the carbon body, which does not contact with raw material gas generation source. Aluminum nitride is produced by reduction and nitridation of raw material gas, and that an aluminum nitride single crystal mainly grows close to the carbon body. Namely, as is shown in Fig. 4, needle or plate formed aluminum nitride single crystals are produced so as to encircle carbon body 6.

It is not theoretically restricted; however, the inventors consider this production reaction as following. Namely, in a region close to the carbon body and the raw material gas generation source, the produced raw material gas will immediately reduce and nitride, and then produces aluminum nitride polycrystal close to the carbon body. Next, raw material gas floating in a space between the raw material gas generation source, which does not contact with carbon body, and the carbon body, which does not contact with raw material gas generation source, and reducing gas (carbon monoxide gas or so) produced from the carbon body are reacted with the polycrystal of a reactor core, and then an aluminum nitride single crystal are grown.

Further, a size of this aluminum nitride single crystal can be adjusted according to the reaction time, as is mentioned hereinbefore. For instance, an aluminum nitride single crystal having outermost diameter of 8mm and length of 100mm can be obtained by lengthen the reaction time.

According to the invention, non-conventional big aluminum nitride single crystal can be produced. The obtained aluminum nitride single crystal can be used in various ways, such as a foundation substrate for light emitting device.

### EXAMPLE

Hereinafter, the present invention will be described in detail using examples and comparative examples; however the present invention is not to be limited thereto. Note that hereinafter, "upstream side" and "downstream side" refer to comparative placements with respect to nitrogen feed opening 2; and "upstream side" defines a side close to nitrogen feed opening 2, while "downstream side" defines a side distant from nitrogen feed opening 2.

### The evaluation methods

### <The evaluation of crystallinity>

A half width of rocking curves was calculated by X-ray diffractometer (by BrukerAXS).

### Example 1

An experiment was proceeded with a single crystal production equipment 1, having a constitution shown in Fig. 1. Cylindrical shaped reaction container 4 was used. As for a raw material, 50mm × 50mm × 1 mm (t) of alumina plate (Al₂O₃) (A479, 99% purity) by KYOCERA Corporation (aluminum oxide 5) was put into reaction container 4 from its upstream side. Input position was directly below nitrogen feed opening 2. Carbon body 6, cut to 5mm × 5mm × 30mm, was set on the upper side of aluminum oxide 5 (a place 20mm distant from downstream side end of the aluminum oxide), making long axis of the body perpendicular to nitrogen gas flow.

The temperature of aluminum oxide 5 and that of carbon body 6 were set to 1950°C.

Nitrogen gas was supplied from nitrogen feed opening 2 so as to make its amount 1 L/min.

An aluminum nitride single crystal deposition was performed by setting a holding time (reaction time) to 30 hours. After the reaction, as is shown in Fig. 4, a deposition (growth) of an aluminum nitride crystal on aluminum oxide 5 encircling carbon body 6 was confirmed. Further, the deposit aluminum nitride crystal was growing from approximately 0.6mm distant from the carbon body, set before reaction. The aluminum nitride crystal, which was the largest of all the deposit, had the outermost diameter of 5 to 6mm and the length of 30mm. Measured weight of the aluminum nitride crystal deposit was 0.7g.

The obtained aluminum nitride crystal was evaluated by X-ray diffractometer (by BrukerAXS). A full width at half maximum of AlN(002) peak was 40 arcsec, and it was recognized that it was an aluminum nitride single crystal.

### Example 2

The same reaction was performed with Example 1, except carbon body 6 was cut to a shape of 1 mm × 1 mm × 30mm.

After the reaction, a deposition (growth) of an aluminum nitride crystal on aluminum oxide 5 was confirmed. Further, the deposit aluminum nitride crystal was growing from approximately 0.6mm distant from the carbon body, set before reaction. The aluminum nitride crystal, which was the largest of all the deposit, had the outermost diameter of 3 to 5mm and the length of 25mm. A full width at half maximum of AIN(002) peak was 43 arcsec, and it was recognized that it was an aluminum nitride single crystal.

### Example 3

The same reaction was performed with Example 1, except carbon body 6 was cut to a shape of 10mm × 10mm × 30mm.

After the reaction, a deposition (growth) of an aluminum nitride crystal on aluminum oxide 5 was confirmed. Further, the deposit aluminum nitride crystal was growing from approximately 0.5mm distant from the carbon body, set before reaction. The aluminum nitride crystal, which was the largest of all the deposit, had the outermost diameter of 4 to 7mm and the length of 35mm. A full width at half maximum of AIN(002) peak was 38 arcsec, and it was recognized that it was an aluminum nitride single crystal.

### Example 4

The same reaction was performed with Example 1, except installation site of carbon body 6 was not on aluminum oxide 5, but 1 mm distant from downstream side end of aluminum oxide 5, without contacting aluminum oxide 5.

After the reaction, a deposition (growth) of an aluminum nitride crystal on aluminum oxide 5 was confirmed. The deposit place of aluminum nitride crystal was on the end part of aluminum oxide, 1 mm distant from the carbon body. The aluminum nitride crystal, which was the largest of all the deposit, had the outermost diameter of 3 to 5mm and the length of 23mm. A full width at half maximum of AIN(002) peak was 50 arcsec, and it was recognized that it was an aluminum nitride single crystal.

### Example 5

The same reaction was performed with Example 1, except installation site of carbon body 6 was not on aluminum oxide 5, but 10mm distant from downstream side end of aluminum oxide 5, without contacting aluminum oxide 5.

After the reaction, a deposition (growth) of an aluminum nitride crystal on aluminum oxide 5 was confirmed. The deposit place of aluminum nitride crystal was on the end part of aluminum oxide, 10mm distant from the carbon body. The aluminum nitride crystal, which was the largest of all the deposit, had the outermost diameter of 3 to 4mm and the length of 20mm. A full width at half maximum of AIN(002) peak was 52 arcsec, and it was recognized that it was an aluminum nitride single crystal.

### Example 6

The same reaction was performed with Example 1, except a substrate for aluminum nitride single crystal growth 7 (its material is an aluminum nitride sintered body) was placed 1 mm distant from downstream side end of aluminum oxide 5 (21 mm distant from carbon body).

After the reaction, a deposition of the aluminum nitride crystal on aluminum oxide 5 and a substrate for aluminum nitride single crystal growth 7 was confirmed. The aluminum nitride crystal on the aluminum oxide was growing from approximately 0.5mm distant from the carbon body, set before reaction. And the aluminum nitride crystal on the substrate for aluminum nitride single crystal growth was deposited on a side opposed to the aluminum oxide. The aluminum nitride crystal, which was the largest of all the deposit, had the outermost diameter of 7 to 9mm and the length of 55mm. A full width at half maximum of AIN(002) peak was 35 arcsec, and it was recognized that it was an aluminum nitride single crystal.

### Example 7

The same reaction was performed with Example 1, except nitrogen flow rate supplied from nitrogen feed opening was 10L/min.

After the reaction, a deposition of a crystal on aluminum oxide 5 was confirmed. Further, the deposit aluminum nitride crystal was growing from approximately 0.5mm distant from the carbon body, set before reaction. The aluminum nitride crystal, which was the largest of all the deposit, had the outermost diameter of 8 to 9mm and the length of 57mm. Measured weight of the aluminum nitride crystal deposit was 2.4g. A full width at half maximum of AIN(002) peak was 60 arcsec, and it was recognized that it was an aluminum nitride single crystal.

### Example 8

The same reaction was performed with Example 1, except nitrogen flow rate supplied from nitrogen feed opening was 10cc/min.

After the reaction, a deposition of a crystal on aluminum oxide 5 was confirmed. Further, the deposit aluminum nitride crystal was growing from approximately 0.6mm distant from the carbon body, set before reaction. The aluminum nitride crystal, which was the largest of all the deposit, had the outermost diameter of 3 to 6mm and the length of 38mm. Measured weight of the aluminum nitride crystal deposit was 0.4g. A full width at half maximum of AIN(002) peak was 63 arcsec, and it was recognized that it was an aluminum nitride single crystal.

### Example 9

The same reaction was performed with Example 1, except the temperature of aluminum oxide 5 and that of carbon body 6 were made to 2050°C.

After the reaction, a deposition of a crystal on aluminum oxide 5 was confirmed. Further, the deposit aluminum nitride crystal was growing from approximately 0.6mm distant from the carbon body, set before reaction. The aluminum nitride crystal, which was the largest of all the deposit, had the outermost diameter of 9 to 11 mm and the length of 48mm. Measured weight of the aluminum nitride crystal deposit was 1.6g. A full width at half maximum of AIN(002) peak was 38 arcsec, and it was recognized that it was an aluminum nitride single crystal.

### Example 10

The same reaction was performed with Example 1, except the temperature of aluminum oxide 5 and that of carbon body 6 were made to 1850°C.

After the reaction, a deposition of a crystal on aluminum oxide 5 was confirmed. Further, the deposit aluminum nitride crystal was growing from approximately 0.5mm distant from the carbon body, set before reaction. The aluminum nitride crystal, which was the largest of all the deposit, had the outermost diameter of 4 to 6mm and the length of 28mm. Measured weight of the aluminum nitride crystal deposit was 0.4g. A full width at half maximum of AIN(002) peak was 65 arcsec, and it was recognized that it was an aluminum nitride single crystal.

### Comparative Example 1

The same reaction was performed with Example 1, except installation site of carbon body 6 was not on aluminum oxide 5, but 100mm distant from downstream side end of aluminum oxide 5, without contacting aluminum oxide 5.

Crystal deposition was not confirmed on aluminum oxide 5 after the reaction.

### Comparative Example 2

The same reaction was performed with Example 1, except carbon body 6 was a carbon powder having an average particle diameter of 2 micron. Surface area per weight unit of the carbon body was 0.6m^{2/}g.

Crystal deposition was not confirmed on aluminum oxide 5 after the reaction.

### Comparative Example 3

The same reaction was performed with Example 1, except nitrogen flow rate supplied from nitrogen feed opening was 0cc/min.

Crystal deposition was not confirmed on aluminum oxide 5 after the reaction.

Considering above, according to the production method of the present invention, it became apparent that an aluminum nitride single crystal of good crystallinity can be efficiently deposit on an intended deposit part. In comparative example 1, clearance between aluminum oxide and carbon body was too big, and that a single crystal could not be obtained. In comparative example 2, clearance between aluminum oxide and carbon body was too small, and that a single crystal could not be obtained. In comparative example 3, nitrogen did not exist in the reaction system, and that single crystal did not deposit. Further, in comparative example 4, nitrogen flow rate was too large, and that single crystal did not deposit.

### List of references

- 1: Single crystal production equipment
- 2: Nitrogen gas feed opening
- 3: Exhaust opening
- 4: Reaction container
- 5: Raw material gas generation source (aluminum oxide)
- 6: Carbon body
- 7: Substrate for an aluminum nitride single crystal growth
- 8: Heater

## Claims

1. A production method of an aluminum nitride single crystal wherein nitrogen gas is circulated in the presence of a raw material gas generation source, which generates an aluminum gas or an aluminum oxide gas, and a carbon body, and then the aluminum nitride single crystal is grown under a heating condition; **characterized in that**,
at least a part of the carbon body does not directly contact with the raw material gas generation source,
at least a part of the raw material gas generation source does not directly contact with the carbon body,
the raw material gas generation source and the carbon body are positioned to make a space in which a clearance between the raw material gas generation source, which does not contact with the carbon body, and the carbon body, which does not contact with the raw material gas generation source, is 0.01 to 50mm, and
a heat temperature and a nitrogen gas flow rate are set so as to satisfy a condition for aluminum nitride deposition in a space between the raw material gas generation source, which does not contact with carbon body, and the carbon body, which does not contact with raw material gas generation source.

2. The production method of the aluminum nitride single crystal as set forth in claim 1, wherein the raw material gas generation source is an aluminum oxide body.

3. The production method of the aluminum nitride single crystal as set forth in claim 2, wherein the carbon body, smaller in size than the aluminum oxide body, is set on the aluminum oxide body.

4. The production method of the aluminum nitride single crystal as set forth in claim 2, wherein a clearance between the aluminum oxide body and the carbon body is 0.05 to 40mm.

5. The production method of the aluminum nitride single crystal as set forth in claim 3 or 4, wherein an aluminum nitride body, a substrate for an aluminum nitride single crystal growth, is placed close to the aluminum oxide body and the carbon body.

6. The production method of the aluminum nitride single crystal as set forth in any one of claims 1 to 5, wherein the nitrogen gas is circulated with an amount of 0.1cc/min. to 100L/min., when converted to 23°C, in a space between the raw material gas generation source, which does not contact with the carbon body, and the carbon body, which does not contact with the raw material gas generation source.
